# EUROPÄISCHE PATENTSCHRIFT

(11) **EP 1 566 088 B1**
(45) Veröffentlichungstag und Bekanntmachung des Hinweises auf die Patenterteilung: **16.01.2008**
(21) Anmeldenummer: 03785678.8
(22) Anmeldetag: 28.11.2003
(51) Int. Cl.: H05K 13/04

(54) **VERFAHREN ZUM FIXIEREN EINES MINIATURISIERTEN BAUTEILS AUF EINER TRÄGERPLATTE**
METHOD FOR FIXING A MINIATURISED COMPONENT TO A CARRIER PLATE
PROCEDE POUR FIXER UN COMPOSANT MINIATURISE SUR UNE PLAQUE DE SUPPORT

(30) Priorität: 29.11.2002 EP 02026650
(43) Veröffentlichungstag der Anmeldung: 24.08.2005
(73) Patentinhaber: Leica Geosystems AG, 9435 Heerbrugg (CH)
(72) Erfinder: WUERSCH, Alain, CH-1814 La Tour-de-Peilz (CH); ROSSOPOULOS, Stephane, CH-1412 Ursins (CH); VERETTAS, Irène, CH-1007 Lausanne (CH); CLAVEL, Reymond, Ch-1377 Oulens/Echallens (CH)
(74) Vertreter: Kaminski, Susanne
(86) Internationale Anmeldenummer: PCT/EP2003/013400
(87) Internationale Veröffentlichungsnummer: WO 2004/052070

(56) Entgegenhaltungen:
- DE-A- 3 531 715
- US-A- 5 081 336
- US-A1- 2001 046 723

## Beschreibung

Die Erfindung betrifft ein Verfahren und eine Vorrichtung zum hochgenauen Fixieren eines miniaturisierten - insbesondere mindestens ein optisches Element tragenden oder enthaltenden - Bauteils auf einer Trägerplatte durch eine Löt-, Schweiss- oder Klebeverbindung.

Durch Anwendung von Mikro-Montagetechnologie, in der automatisierte Robotermontagestationen eingesetzt werden, können Bauteile mit einer hohen Genauigkeit, nämlich fast der Positionierungsauflösung des beispielsweise als Greifer ausgebildeten Manipulators, die unter 1 Mikron beträgt, auf einer Trägerplatte positioniert werden. Trotz der hohen Positionierungsgenauigkeit der Bauteile auf der Trägerplatte vor dem Verbindungsvorgang sind nur bedingt entsprechend genaue End-Fixiergenauigkeiten erzielbar, da die Positionierungsgenauigkeit oft während des Verbindens des Bauteils mit der Trägerplatte durch Löten, Kleben oder Schweissen herabgesetzt wird. Ein Grund hierfür ist das Auftreten einer insbesondere vertikalen - zur Trägerplatte senkrechten - Schrumpfung der Verbindungsnaht zwischen dem Bauteil und der Trägerplatte während des Abkühlens des Lots beim Löten bzw. der Schweissnaht beim Schweissen oder des Aushärtens des Klebstoffs beim Kleben.

Die bei thermischen Fügeverfahren örtlich begrenzt eingebrachte Wärme verursacht Dehnungen, wobei das umgebende kalte Material in der Fügezone Stauchungen erzwingt. Bei der anschliessenden Abkühlung der Verbindungsnaht auf Raumtemperatur schrumpfen die vorher gestauchten Bereiche unter erneuter Behinderung durch das kalte Umgebungsmaterial. Es kommt unvermeidlich zu Schrumpfspannungen bzw. Eigenspannungen und zu Verzug bzw. Schrumpfungen. Verzug und Eigenspannungen hängen insbesondere ab von der Wärmeeinbringung, der Wärmeableitung und der Schrumpfbehinderung bzw. dem Verspannungsgrad. Dem Fachmann ist bekannt, dass eine günstige Schrumpfmöglichkeit geringe Verspannungen und Eigenspannungen zur Folge hat, wohingegen eine geringe Schrumpfmöglichkeit zu grossen Verspannungen, d.h. grossen Eigenspannungen führt. Besonders bei Anwendung eines thermischen Fügeverfahrens, dem Löten und dem Schweissen, bei denen ebenfalls der Manipulator einer Erwärmung unterliegt, kommt es bei der anschliessenden Abkühlung neben der Schrumpfung der Verbindungsnaht zu einem zusätzlichen Schrumpfen des Manipulators. Wird das Bauteil vom Manipulator bzw. Greifer fest gehalten, löst sowohl die Schrumpfung der Verbindungsnaht, als auch die durch das Abkühlen des gesamten Bauteils, des Greifers und weiterer Komponenten hervorgerufene Schrumpfung Spannungen bzw. Zugkräfte zwischen dem Bauteil und der Trägerplatte aus, die zum Teil freigesetzt werden, sobald das Bauteil vom Manipulator bzw. Greifer losgelassen wird. Hierdurch kommt es zu einer unerwünschten Verrückung des Bauteils, wodurch die Endgenauigkeit der Fixierung des Bauteils entsprechend herabgesetzt wird. Die nicht freigesetzten Spannungen haben Eigenspannungen zur Folge, die die Festigkeit der Verbindung schwächen können. Die beschriebene Problematik ist zwar besonders bei thermischen Fügeverfahren, vor allem dem Löten, Schweissen und Schmelz- oder Klebplastisolkleben, von Bedeutung, jedoch ergibt sich eine ähnliche Problematik ebenfalls beim kalten Kleben, sofern das Härten des Klebstoffs mit einer Schrumpfung und/oder Erwärmung einhergeht.

In der WO 00/28376, deren Offenbarung im Rahmen der folgenden Darstellung einen Teil des Inhalts dieser Beschreibung darstellt, wird eine Einrichtung einschliesslich einem Verfahren - insbesondere einem Lötverfahren - zum thermisch stabilen Halten eines miniaturisierten Bauteils beschrieben. Das Lötverfahren wird von einer Roboterstation mit einem Greifer durchgeführt. Der Greifer erfasst das Bauteil, positioniert es zu äusseren Bezugspunkten geringfügig beabstandet über einer Trägerplatte, hält es während einer Laserbestrahlung in seiner Lage und gibt es frei, nachdem die Befestigung hergestellt worden ist. Bei der Konstruktion des Greifers muss gemäss der WO 00/28376 die grundsätzliche Wahl getroffen werden, entweder den Greifer nahezu unendlich starr zu gestalten, so dass er sich der Metallschrumpfung widersetzt, oder einen Greifer mit definierter elastischer Nachgiebigkeit in vertikaler Richtung - senkrecht zur Trägerplatte - zu verwenden. Im letzteren Fall wird die Schrumpfung nicht behindert, sondern in einer definierten Raumrichtung, insbesondere senkrecht zur Trägerplatte, gestattet. Gemäss WO 00/28376 wird die zweite Lösung mit dem nachgiebigen Greifer gegenüber der ersten mit dem starren Greifer bevorzugt, da eine Konstruktion, die sich als nichtverformbar gegenüber der Kraft verhalten kann, die durch die Schrumpfung des Zinnmaterials erzeugt wird, zu robust wäre, als dass sie für eine Roboterstation hoher Genauigkeit geeignet wäre. Die Metallschrumpfung erzeugt eine mechanische Belastung, die grösser als die Grenzzugfestigkeit des Lötmaterials sein kann und somit zu einem Versagen der Fügung führen könnte. In einem fiktiven Beispiel wird anhand eines definierten Bauteils der Grösse 2 x 2 x 3 mm demonstriert, dass bei einer 1 mm dicken Zinnschicht eine Wärmeschrumpfung von 4 µm eine Spannung von 288 N/mm² hervorruft. Da die auf das Zinn ausgeübte Belastung in diesem Fall viel höher als seine Bruchgrenze ist, ergibt sich zwangsläufig ein Fügefehler, der zu einem Versagen der gesamten Befestigung führen kann. Ausserdem wird in der WO 00/28376 darauf hingewiesen, dass durch die Verwendung einer elastischen Konstruktion für den nachgiebigen Greifer die endgültige Befestigungsgenauigkeit nicht verschlechtert wird, wenn man annimmt, dass die Greiferkonstruktion ausreichend starr ist, um während der Bestrahlungsdauer das Halteteil in einer festen Position zu halten. Die mechanischen Spannungen treten angeblich nur auf, wenn die Zinnschicht ihre Phase ändert und erneut in den festen Zustand zurückkehrt. Von diesem Zeitpunkt an beteiligt sich die Verformbarkeit des Greifers. In der WO 00/28367 wird sodann ein Greifer beschrieben, dessen Höhenposition während des Abkühlens bzw. Aushärtens der Verbindungsnaht passiv unter Gegenwirken einer Feder elastisch nachgibt. Bei diesem passiven Verfahren ist die nach dem Erstarren erreichte Höhenposition somit abhängig von der inneren Spannung der Verbindungsnaht bzw. der Zugkraft auf den Greifer während des Abkühl- bzw. Aushärteprozesses, die wiederum abhängig von der Dicke der Löt- bzw. Schweiss- oder Klebschicht ist. Die Dicke dieser Schicht variiert jedoch aufgrund von Toleranzen, weshalb die Endposition des Bauteils stark vom Zufall abhängig ist. Zwar ist es in der Theorie möglich, bei genauer Kenntnis aller Prozessparameter die Vorpositionierung des Bauteils unter Berücksichtigung der Schrumpfung durchzuführen. Unter anderem aufgrund von Fertigungstoleranzen und Temperaturinkonsistenzen ist die Schrumpfung jedoch nur bedingt vorausbestimmbar, so dass Abweichungen der Endposition nicht vermeidbar sind. Eine höchste Genauigkeit ist hier somit nur bei idealen und genau bekannten Verfahrensbedingungen erzielbar. Ausserdem ist es problematisch, einerseits die elastische Beweglichkeit der Höhenposition, andererseits ein exaktes Vor-Positionieren des Bauteils bei einer gewissen Höhenposition zu gewährleisten, ohne dass die Schrumpfung durch eine zu hohe Federkonstante behindert wird.

Aus der US 2001/0046723 A1 sind ein Verfahren und eine Vorrichtung zur Lötbefestigung eines Bauteils auf einem Substrat bekannt. Mittels eines Greifkopfs wird das Bauteil, insbesondere ein Flip-Chip Halbleiterbauteil, über dem Substrat positioniert und abgesenkt, bis es zu einem Kontakt zwischen dem Bauteil und dem Substrat kommt. Das Bauteil wird mit einer bestimmten Anpresskraft, die von einem Kraftsensor am Greifkopf erfasst wird, auf das Substrat gedrückt. Während die Anpresskraft kontinuierlich überwacht wird, erfolgt ein Erhitzen des Bauteils. Das Schmelzen des Lötzinns wird durch ein Abnehmen der erfassten Anpresskraft detektiert, worauf die mittels des Greifers auf das Bauteil ausgeübte Kraft vorzugsweise bis auf Null reduziert wird und der Greifkopf das Bauteil loslässt. Das auf dem flüssigen Lötzinn positionierte Bauteil kann somit den Kräften der Oberflächenspannung nachgeben und sich selbst zentrieren. Das Erzielen einer hohen End-Positionsgenauigkeit des Bauteils auf dem Substrat nach dem Erstarren des Lötzinns ist nicht möglich, da sich das Bauteil nach dem Loslassen frei positioniert und sowohl der Oberflächenspannung des Lotzinns als auch dessen Schrumpfung bei der Erstarrung ungehindert ausgesetzt ist.

In der DE 35 31 715 A wird ein Verfahren zum Verlöten oberflächenmontiertbarer Bauelemente auf mit Leitermustern versehenen Schaltungsträgerplatten unter Wiederverflüssigung eines im Bereich der Lötstelle vorgesehenen Lotbelages beschrieben. Bei dem Verfahren wird ein zu verlötendes Bauelement auf die Schaltungsträgerplatte aufgesetzt und positioniert und dann Wärmeenergie zur Lötverflüssigung mittels eines in den Bereich der Lötstellen bewegbaren, geheizten Lötwerkzeugs zugeführt. Das Lötwerkzeug wird hierbei auf die Leiterbahnen der Schaltungsträgerplatte nahe den Lötstellen derart aufgesetzt, dass die zur Lotverflüssigung notwendige Wärmeenergie durch Wärmeleitung über die Leiterbahnen der Schaltungsträgerplatte zur Lötstelle gelangt. Die Positionierung des Bauelements wird in solcher Weise vorgenommen, dass das Bauelement keine Verschiebungen in Richtung parallel zur Ebene der Schaltungsträgerplatte durchführen kann. Das Bauelement bleibt jedoch in Richtung normal zur Schaltungsträgerplatte beweglich, um sich in Richtung auf die Schaltungsträgerplatte unter dem Anpressdruck des gesonderten Andrückwerkzeugs absenken zu können, sobald sich das Lot der Lötbeläge an den Anschlusskontakten verflüssigt. Als gesondertes Andrückwerkzeug wird ein mit einer Kraft in der Grössenordnung eines bestimmten Bruchteils von 1 N vorgespannter Stempel genannt. Das in der DE 35 31 715 A beschriebene Verfahren dient dazu, ein Bauelement unter Aufrechterhaltung der Positionierung parallel zur Trägerplatte mindestens während des Aufsetzens des Lötwerkzeuges auf die Leiterbahn mit vorbestimmtem Anpressdruck gegen die Trägerplatte zu drücken. Dieses Verfahren ist geeignet für die Montage von oberflächenmontiertbaren elektrischen Schaltungsbauteilen, die in Richtung parallel zur Trägerplatte einigermassen präzise positioniert werden müssen, damit ein definierter Kontakt zu Leitungsbahnen auf der Trägerplatte hergestellt wird und es zu keinen elektrischen Kontaktunterbrechungen oder Kurzschlüssen kommt. Da die zur Trägerplatte senkrechte Endposition der elektrischen Schaltungsbauteile auf einer Trägerplatte nach dem Fixiervorgang bei dem offenbarten Verfahren nur eine untergeordnete Rolle spielt, sondern lediglich ein gewisser Anpressdruck der Bauteile auf die Trägerplatte bei Verflüssigung des Lötmaterials sichergestellt sein muss, findet sich in der DE 35 31 715 A kein Hinweis auf eine Lösung, eine hochpräzise definierte - insbesondere senkrechte - Endpositionierungsgenauigkeit des Bauteils relativ zur Trägerplatte nach Erstarrung der Lötnaht herzustellen. Es werden im Rahmen der DE 35 31 715 A keine Massnahmen zur Sicherstellung einer positionsgenauen Endposition des Bauteils und einer spannungsarmen Fügenaht getroffen. Da die in dem beschriebenen Verfahren die Wärmeeinbringung einseitig erfolgt, kommt es zwangsläufig zu im Bereich der Mikrooptik inakzeptablen Asymmetrien bei der Schrumpfung. Das in der DE 35 31 715 A beschriebene Verfahren ist ungeeignet als ein Verfahren der Mikro-Montagetechnologie zum hochgenauen Fixieren von Mikrobauteilen, die insbesondere Mikrooptiken enthalten.

Somit besteht auf dem Gebiet der Mikro-Technologie weiterhin ein Bedarf für eine Verbesserung der Positionierungsgenauigkeit von miniaturisierten Bauteilen, da allein durch die oben beschriebene passive Höhenpositionsverstellung die durch die Schrumpfung erzeugte Spannung im System, das insbesondere aus dem Bauteil, der Verbindungsnaht, der Trägerplatte und der gesamten Halterung besteht, nicht vollständig ausgeglichen wird und eine hohe End-Positionsgenauigkeit bei gleichzeitiger fehlerfreier Fügenaht nicht sichergestellt ist.

Der Erfindung liegt die Aufgabe zugrunde, die End-Positionsgenauigkeit miniaturisierter Bauteile auf einer Trägerplatte nach dem Fixieren der Fügestelle zu verbessern, Spannungen im System, insbesondere Eigenspannungen an der Fügestelle, zu vermeiden und Fügefehler, insbesondere Risse, Bindefehler und sonstige Unregelmässigkeiten der Fixierung, zu vermeiden.

Diese Aufgabe wird durch die Verwirklichung der Merkmale der unabhängigen Ansprüche gelöst. Merkmale, die die Erfindung in alternativer oder vorteilhafter Weise weiterbilden, sind den abhängigen Ansprüchen zu entnehmen.

Erfindungsgemäss wird zum Fixieren eines miniaturisierten Bauteils auf einer Trägerplatte das Bauteil mit einem Greifer einer Roboterstation gefasst, festgehalten und über oder auf der Trägerplatte relativ zu äusseren Bezugspunkten positioniert. Anschliessend wird eine Verbindung zwischen dem Bauteil und der Trägerplatte durch Löten, Kleben oder Schweissen hergestellt. Das Erstarren der Löt- bzw. Klebemasse oder der Schweissnaht geht mit einer Schrumpfung - oder gegebenenfalls einer Expansion beispielsweise bei einer Kunststoffklebemasse - der Verbindungsnaht zwischen dem Bauteil und der Trägerplatte einher, wobei gleichzeitig mit der Schrumpfung - bzw. der Expansion - der Greifer eine gesteuerte bzw. geregelte vertikale Bewegung in Richtung zur Trägerplatte - bzw. weg von der Trägerplatte - gegebenenfalls bis zu einer definierten Sollposition ausführt und damit der Schrumpfung - bzw. der Expansion - aktiv, gegebenenfalls kontinuierlich, im Wesentlichen nachgibt. Am Greifer angreifende Zugkräfte werden kompensiert und gegebenenfalls vollkommen ausgeglichen. Dabei wird der Aufbau von hohen inneren Spannungen weitgehend verhindert, so dass die eventuell verbleibende Restspannung beim Lösen des Bauteils vom Greifer keine Positionsänderung mehr auslöst. Da in der Regel die Fixiervorgänge mit einer Schrumpfung und nicht mit einer Expansion der Verbindungsnaht einhergehen, wird im Folgenden stets der Begriff "Schrumpfung" verwendet. Selbstverständlich ist es möglich, die Lehre der Erfindung auch auf eine expandierende Erstarrung zu übertragen. Dies könnte theoretisch bei Einsatz eines synthetischen Fügematerials der Fall sein. Ausserdem ist im Folgenden unter einer Zugkraft nicht zwangsläufig nur eine positive Zugkraft, sondern gegebenenfalls auch eine negative Zugkraft zu verstehen. Im Fall einer Expansion anstelle einer Schrumpfung ist ausserdem unter der Bewegung in senkrechter Richtung zur Trägerplatte eine Bewegung in senkrechter Richtung weg von der Trägerplatte zu verstehen. Mit der Fügenaht oder Verbindungsnaht ist nicht nur ein mit Lot gefüllter Lötspalt oder eine Lötfuge, sondern auch eine Schweissnaht, eine mit Klebstoff gefüllte Klebefuge oder ein Klebespalt, oder jede andere Füge- oder Verbindungsnaht gemeint.

Bei der Lösung geht die Erfindung von dem Grundgedanken aus, mit der gesteuerten bzw. geregelten Bewegung des Greifers die aufgrund der Schrumpfung auftretende Spannung bzw. Zugkraft zwischen dem Bauteil und der Trägerplatte im Wesentlichen auszugleichen, gegebenenfalls bis eine definierte Sollposition erreicht ist, um eine unerwünschte Depositionierung des Bauteils während der Schrumpfung und/oder beim Lösen vom Greifer zu vermeiden.

Die Bewegung des Greifers kann gesteuert und/oder geregelt werden. Das Steuern kann insbesondere durch eine automatische Sequenz, die einem Algorithmus folgt, der vor allem aufgrund der Materialeigenschaften und dem daraus ergebenden Schrumpfungsverhalten gewählt wird und gegebenenfalls durch Messen der Umgebungstemperatur oder der Temperatur der unter Schrumpfung abkühlenden Verbindungsnaht beeinflusst wird, erfolgen. Die Bewegung des Greifers wird beispielsweise geregelt, indem die durch die Schrumpfung auftretende Spannung insbesondere mittels Messen der Kraft, die auf den Greifer als Folge der erstarrenden Verbindungsnaht ausgeübt wird, bestimmt oder die vertikalen elastischen Positionsverschiebung des Greifers während des Schrumpfens gemessen wird.

Ein Vorteil der genannten Massnahmen ist, dass durch das Ausgleichen der Spannung bzw. Zugkraft während des Schrumpfens die Endgenauigkeit der Montage der Bauteile wesentlich erhöht wird und keine hohen inneren, die Qualität der Verbindungsnaht mindernden Eigenspannungen verbleiben.

Die Erfindung betrifft ausserdem Greifvorrichtungen und Manipulatoren von Robotermontagestationen, die mit Kraft- und/oder Positionssensoren ausgestattet sind. Durch diese Sensoren können nicht nur die inneren Spannungen und Kräfte an der Verbindungsnaht und/oder die Position des Greifers während des Schrumpfens bestimmt, sondern auch die Bewegung des Greifers während des Schrumpfens geregelt werden.

Das erfindungsgemässe Verfahren und die erfindungsgemässe Greifvorrichtung eignen sich insbesondere für die Montage von miniaturisierten Bauteilen, auch Mikro-Komponenten genannt, die optische Elemente wie beispielsweise Linsen, optische Fasern, Dioden, etc., enthalten.

Das erfindungsgemässe Verfahren kann von einer Steuerungs-Regelungs-Einheit ausgeführt werden, die das Fassen und Festhalten des Bauteils durch den Greifer, das Bewegen des Greifers durch die Roboterstation und das Herstellen der Verbindung durch eine Vorrichtung zum Herstellen der Verbindung, beispielsweise einer Laserlötanlage, steuert und/oder regelt.

Nachfolgend werden das erfindungsgemässe Verfahren und die erfindungsgemässe Greifvorrichtung detailliert dargestellt und anhand von allgemeinen Beispielen näher beschrieben, wobei auch auf weitere Vorteile der Erfindung eingegangen wird.

Das erfindungsgemässe Verfahren wird vor allem in automatischen Robotermontagestationen verwendet, da alle erforderlichen Aufgaben durch Roboter ausgeführt werden können, die mit Positionierungssensoren versehen sind. Jedes Bauteil wird im Raum durch einen Roboter in den sechs Freiheitsgraden positioniert und festgelegt. Ein Beispiel für ein Verfahren zur Befestigung eines insbesondere modular gefassten, miniaturisierten Bauteils auf einer Trägerplatte durch beispielsweise eine Lötverbindung ist in der oben erwähnten WO 99/26754 beschrieben. Weitere Verbindungsmethoden sind unter anderem Schweissen, wie zum Beispiel Laserpunktschweissen oder elektrisches Widerstandspunktschweissen, oder Kleben.

Die Endgenauigkeit hängt beim ungehinderten Schrumpfen direkt von der Wiederholbarkeit des Schrumpfens ab. Während der Abkühlungsphase beim Löten und Schweissen bzw. der Aushärtung beim Kleben ändert die Schrumpfung an der Verbindungsnaht zwischen dem Bauteil und der Trägerplatte unvermeidbar die Bauteileinstellung entlang der vertikalen Achse. Bei einem schräg positionierten Bauteil oder ungleichmässigen Fügeflächen betrifft die Schrumpfung auch die horizontale Ausrichtung des Bauteils parallel zur Oberfläche des Bauteils. Jedoch kann diese horizontale Verschiebung einerseits durch eine entsprechende, aus dem Stand der Technik bekannte Gestaltung des Fügeoberfläche, als auch durch gezieltes Einschränken der Freiheitsgrade bei der Erstarrung verhindert werden. Da die horizontale Verschiebung im Vergleich zum vertikalen Versatz - in Richtung zur Trägerplatte - gering ist, sind die durch Verhinderung des horizontalen Versatzes entstehenden Restspannungen in der Fügenaht gering und unkritisch. Die Schrumpfung zeigt bei Kenntnis der Prozessparameter eine sehr gute Wiederholbarkeit und kann als Funktion des Zwischenraums zwischen der Trägerplatte und der Bauteilbasis kalibriert werden. Eine gute Befestigungsgenauigkeit kann nur erreicht werden, wenn das Schrumpfen bei der Positionierung im Voraus mit einkalkuliert worden ist, bevor das Löt-, Klebe- oder Schweissverfahren beginnt. Dies erfolgt zum Beispiel, indem die Grösse der Schrumpfung bei der vertikalen Ausrichtung des Bauteils über der Trägerplatte bereits vorab berücksichtigt wird. Ist die Basis des Bauteils mit einer sphärischen oder zylindrischen Symmetrie ausgestattet, werden die seitliche Genauigkeit und die Winkelgenauigkeit durch die Schrumpfung nicht geändert.

Das Bauteil wird während der Fixierung von einem Greifer der Roboterstation festgehalten, wobei der Greifer in vertikaler Richtung, d.h. lotrecht zur Trägerplatte, durch die Roboterstation aktiv bewegt wird. Hierzu ist der Greifer an einer Halterung oder einem Arm der Roboterstation befestigt, welche zumindest in vertikaler Richtung zur Trägerplatte absenkbar und gegebenenfalls in allen 6 Freiheitsgraden beweglich sind. Sobald die Schrumpfung einsetzt, wird der Greifer gesteuert und/oder geregelt vertikal zur Trägerplatte im Ausmass der Schrumpfung aktiv bewegt, um den zu hohen Aufbau einer vertikalen Zugkraft, die durch die vertikale Schrumpfung entsteht, zwischen dem Bauteil und dem Greifer und somit den zu hohen Aufbau innerer Spannungen in der Verbindungsnaht zu verhindern, gegebenenfalls bis die Sollposition erreicht ist. Gegebenenfalls ist es möglich, anstelle der positiven Zugkraft eine negative Zugkraft, also eine Druckkraft einzustellen. In diesem Fall übt der Greifer einen gewissen Druck auf die Verbindungsnaht auf, der sich durch die Schrumpfung reduzieren würde, jedoch durch das Nachstellen des Greifers aufrechterhalten wird. Es wird bevorzugt, dass der Schrumpfung kontinuierlich durch vertikales Verstellen nachgefahren wird. Wesentlich ist, dass die Kompensation der Schrumpfung durch die vertikale Bewegung des Greifers in Richtung zur Trägerplatte derart fein gesteuert und/oder geregelt wird, dass ein Auftreten von Spannungen, Zug- und/oder Zerrkräften im System aus Bauteil, Verbindungsnaht, Trägerplatte, Greifer und Halterung weitgehend vermieden wird und die Sollposition erreicht wird.

In er möglichen Ausführungsform wird das Verstellen in vertikaler Richtung begrenzt, indem nach Erreichen einer zuvor bestimmten vertikalen Sollposition - senkrecht zur Trägerplatte - der Greifer in Richtung zur Trägerplatte blockiert wird. Zwar treten hierdurch grössere innere Spannungen in der Verbindungsnaht und im gesamten System auf, jedoch ist es möglich, die Endpositionierungsgenauigkeit zu erhöhen. Zu beachten ist jedoch, dass die Sollposition und diejenige Position, die bei ungehinderter Schrumpfung eingenommen werden würde, nur geringfügig differieren dürfen, da ansonsten zu hohe Spannungen, insbesondere Eigenspannungen, auftreten, die die Fixierungsqualität und Endpositionierungsgenauigkeit verschlechtern. Beste Resultate werden bei genauer Kenntnis des Schrumpfungsgrades und exaktem Nachfahren der Schrumpfung erreicht.

Aufgrund der Wiederholbarkeit der Schrumpfung kann das Schrumpfungsverhalten der eingesetzten Materialien vorab experimentell oder durch Simulation bestimmt, mit den dabei ermittelten Daten ein Algorithmus festgelegt und damit eine automatische Sequenz in der Roboterstation implementiert werden, durch die dann die Bewegung des Greifers während der Schrumpfung gesteuert wird. Da die Erstarrungsgeschwindigkeit insbesondere von der Umgebungstemperatur abhängt, sollte der Algorithmus der jeweiligen Umgebungstemperatur anpassbar sein, sofern eine konstante Umgebungstemperatur während des gesamten Fertigungsprozesses nicht gewährleistbar ist.

In einer weiteren Ausführungsform der Erfindung ist ein Kraftsensor in den Greifer integriert. Sobald eine Verbindungsnaht zwischen dem Bauteil und der Trägerplatte hergestellt ist und die Basis des vom Greifer festgehaltenen Bauteils mit dem noch flüssigen Löt-, Klebe- oder Schweissmedium benetzt ist, wird die Spannung der flüssigen bzw. weichen Verbindungsnaht - insbesondere mittels eines Kraftsensors, der die vertikale Ist-Zugkraft am Greifer misst - gemessen, bevor die Schrumpfung einsetzt. Der ermittelte Messwert dient dann als Soll-Wert in einem Regelkreis, der die Bewegung des Greifers über eine Regeldifferenz regelt, die sich aus der Differenz des Soll-Werts und des während des Schrumpfens gemessenen Messwerts ergibt. Löst die Schrumpfung nun eine Zugkraft in Richtung der Trägerplatte auf das Bauteil aus, wird der Greifer so lange vertikal in Richtung der Trägerplatte bewegt, bis die Zugkraft grösstenteils kompensiert ist, d.h. der Soll-Wert erreicht ist.

Die Funktionsweise eines solchen Regelkreises ist bekannt. Die Führungsgrösse wird im oben beschriebenen Verfahren direkt oder indirekt durch eine mechanische Soll-Spannung an der Verbindungsnaht vorgegeben. Die Regelgrösse des Regelkreises wird direkt oder indirekt durch eine mechanische Ist-Spannung an der Verbindungsnaht gebildet. Die Soll-Spannung und die Ist-Spannung müssen nicht explizit ermittelt werden, da die Vorgabe eine Soll-Zugkraft und die Messung einer Ist-Zugkraft, die jeweils ebenfalls negativ sein können, am Greifer einfacher zu ermitteln sind. Das Angleichen der Ist-Spannung an die Soll-Spannung erfolgt durch die aktive Bewegung des Greifers in Richtung zur Trägerplatte.

In einer anderen Ausführungsform der Erfindung ist der Greifer relativ zur Roboterstation und vertikal gegenüber der Trägerplatte geringfügig frei beweglich ausgeführt. Diese Freibeweglichkeit kann beispielsweise durch eine Feder, die eine geringe vertikale Bewegung des Greifers erlaubt und über die der Greifer mit der Roboterstation verbunden ist, erreicht werden. In diesem Fall ist der Greifer mit einem Positionsdetektor ausgestattet, der die gegenüber der Roboterstation relative Bewegung misst. Die relative vertikale Position des Greifers wird wiederum gemessen, sobald eine Verbindungsnaht zwischen der Basis des durch den Greifer festgehaltenen Bauteils und der Trägerplatte hergestellt ist, jedoch bevor die Schrumpfung einsetzt. Der ermittelte Messwert, d.h. die relative vertikale Position, fliesst dann als Soll-Wert in einen Regelkreis ein, der die vertikale Bewegung des Greifers über ein Rückkopplungssignal aus dem Vergleich des Soll-Werts mit der während der Schrumpfung gemessenen Ist-Position regelt. Wird nun aufgrund der durch die Schrumpfung ausgelösten Zugkraft die vertikale Position des Greifers etwas in die Richtung der Trägerplatte verschoben, so wird diese erzwungene Verschiebung unmittelbar darauf durch eine entsprechende aktive, vertikale Positionsnachjustierung des Greifers durch die Roboterstation wieder ausgeglichen. Die genannte geringfügige freie Beweglichkeit dient somit im Wesentlichen zu Messzwecken.

Selbstverständlich können auch mit den Regelkreisen, die Kraft- bzw. Positionsdetektoren einsetzen, durch automatische Sequenzen gesteuerte Bewegungen zusätzlich feinadjustiert werden.

Da der aktuelle Schrumpfgrad während des Abkühlens von der aktuellen Temperatur der Verbindungsnaht abhängt, ist es überdies möglich, anstelle der oder zusätzlich zur Erfassung der Spannung über Kraft- oder Wegmessung die aktuelle Temperatur der Verbindungsnaht, beispielsweise mittels kontaktloser Oberflächentemperaturmessung, zu ermitteln und hieraus die Spannung zu bestimmen und das vertikale Verstellen des Greifers zu steuern.

Da die Befestigung des Bauteils auf der Trägerplatte durch eine Roboter-Zusammenbaustation durchgeführt wird, wird die Befestigungsgenauigkeit auch durch die Greiffestigkeit des Greifers beeinflusst, der an dem Roboterarm angebracht ist. Der Greifer muss das Bauteil erfassen, es relativ zu äusseren Bezugspunkten positionieren, es während dem Löten, Schweissen oder Kleben in seiner Lage halten und es freigeben, nachdem die Befestigung hergestellt worden ist. Aufgrund der kleinen Abmessungen des Bauteils, beispielsweise 2 x 2 x 3 mm, ist es schwierig, dieses gleich bleibend zu ergreifen.

Die notwendige Greifkraft kann auf unterschiedliche Weise bereitgestellt werden, wobei es aber wegen der kleinen Abmessung des Bauteils schwierig ist, eine Kraft mit ausreichender Vorsicht auszuüben. Die Greifkraft muss einerseits so gross sein, dass es zu keiner relativen Bewegung des Bauteils gegenüber dem Greifer im Festhaltezustand kommt, andererseits muss sie so klein sein, dass das Bauteil nicht beschädigt wird. Aufgrund der erhöhten Befestigungsgenauigkeit, die verlangt wird, muss das Bauteil von dem Greifer freigegeben werden, ohne dass seine Position durch das Freigeben beeinträchtigt wird. Eine Vielzahl an Lösungen, bei denen die Greifkraft durch eine mechanische Wirkung erzeugt wird, kommt nicht in Betracht, da während der Freigabephase die Befestigungsgenauigkeit beeinträchtigt werden könnte. Als geeignete Lösung hat sich ein Greifer erwiesen, dessen Haltekraft durch einen Magneten, insbesondere einen Elektromagneten, erzeugt wird. Das Prinzip der Aufbringung der Haltekraft mittels eines Elektromagneten ist aus dem Stand der Technik bekannt und wird beispielsweise in der WO 00/28367 beschrieben.

Nachfolgend wird das erfindungsgemässe Verfahren anhand zweier allgemeiner Beispiele näher beschrieben.

In einem ersten Beispiel erfolgt die Lötbefestigung miniaturisierter Bauteile auf einer mit einer Metallbeschichtung beschichteten Trägerplatte und durch Steuerung der Bewegung des Greifers mittels einer automatischen Sequenz.

Das folgende Löt-Verfahrensprinzip ist z.B. teilweise in der WO 99/26754 beschrieben. Das Bauteil wird an der zu verbindenden Basisseite mit Lötmaterial beschichtet, vom Greifer der Roboterstation gefasst und in seiner Position oberhalb der Trägerplatte so ausgerichtet, dass ein kleiner Spalt für die Lötverbindung und zusätzlich ein Spielraum für die Kompensation der Schrumpfung zwischen der Basis des Bauteils und der Trägerplatte bleibt. Hierzu wird in Vorversuchen das Ausmass der Schrumpfung bestimmt. Ergeben diese Versuche zum Beispiel eine Amplitude der Schrumpfung von -4.5µm ±0.5, so positioniert die Roboterstation das Bauteil an seiner vertikalen Endposition +4.5µm, d.h. die zu erwartende Schrumpfung wird der vertikalen Höhe vor dem Verbinden hinzugerechnet. Anschliessend wird mit einem Laser das Lötmaterial an der Basis des Bauteils zum Schmelzen gebracht, so dass sich zwischen der Basis des Bauteils und der Trägerplatte ein Tropfen aus Lötmaterial ausformt, der den Spalt füllt und die Verbindung zwischen den beiden Teilen herstellt.

Nun wird, in Verbesserung dieses Verfahrens, unmittelbar nach Abschalten des Lasers die automatische Sequenz auf Basis eines Algorithmus gestartet, wodurch die nachgebende vertikale Bewegung des Greifers in Richtung Trägerplatte während des Schrumpfens aktiv gesteuert wird:

Die Temperatur T bildet bei der Abkühlung eine Asymptote, die bei der Fügetemperatur T_{f} startet und sich der Umgebungstemperatur annähert. Die vertikale Schrumpfung x ist proportional zur Abkühlung, so dass für die Festlegung der automatischen Sequenz gilt: Δx ≈ α (T_{f} -T), wobei α der angenäherte thermische Expansionskoeffizient des Systems ist.

Abhängig von den eingesetzten Materialien dauert die Abkühlphase etwa 2 bis 10 Sekunden. Im Anschluss wird das Bauteil von dem Greifer wieder freigegeben.

Aus dem Temperaturverlauf ergibt sich somit eine Funktion für die vertikale Position des Greifers. Diese Funktion kann selbstverständlich den Umgebungsbedingungen, insbesondere der Umgebungstemperatur, automatisch angepasst werden. Da die vertikale Verstellung gesteuert erfolgt und der Greifer das Bauteil stets bei gleicher vertikaler Position freigibt, ist die Positionsgenauigkeit im Wesentlichen stets konstant.

In einem zweiten Beispiel wird im Folgenden eine Lötbefestigung eines Bauteils auf einer Trägerplatte beschrieben, wobei die Ausgleichsbewegung des Greifers mit Regelkreisen, die Kraft- und/oder Positionsdetektoren verwenden, geregelt erfolgt.

Im Gegensatz zu dem in der WO 99/26754 beschriebenen Verfahren wird in diesem Beispiel das Lötmaterial direkt auf die Trägerplatte aufgebracht. Nachdem das Bauteil von der Roboterstation berührungsfrei über der Trägerplatte in Position gebracht ist, wird für n Sekunden ein Laser eingeschaltet, um das Lötmaterial zu schmelzen, wobei n<tₘₐₓ und tₘₐₓ= Dauer des Laserimpuls. Das Lötmaterial kann entweder direkt von einem oberhalb der Trägerplatte angeordneten Laser schräg angestrahlt werden oder es wird der Laser unterhalb einer - für Laserstrahlen transparenten und mit einer Metallschicht beschichteten - Trägerplatte angebracht, worauf im letzteren Fall der Laserstrahl die Trägerplatte durchdringt, auf die Metallschicht auftrifft, die Metallschicht erwärmt und dadurch das Lötmaterial zum Schmelzen bringt. Danach wird der Greifer, der mit einem Kraft- oder Positionsdetektor ausgestattet ist, mit dem Bauteil zur Trägerplatte abgesenkt, sodass das geschmolzene Lötmaterial die Basis des Bauteils benetzt, worauf der Greifer samt Bauteil auf eine gegenüber der Trägerplatte vertikale Position angehoben wird, die der festgelegten Endmontageposition plus der zu erwartenden Schrumpfung entspricht. Der Greifer muss die Endposition vor tₘₐₓ erreicht haben. Danach wird der Laser abgeschaltet und der Messwert, aus dem die innere Spannung oder die Zugkraft abgeleitet werden kann, des Detektors zum Zeitpunkt des Abschaltens gespeichert. Hierauf wird die Folgeregelungssequenz gestartet, während das Lötmaterial abkühlt. Der gespeicherte Detektormesswert wird hierzu als Soll-Wert für die Rückkopplungsschleife zur Regelung der vertikalen Bewegung des Greifers verwendet. Nach dem Erstarren des Lötmaterials wird das Bauteil vom Greifer gelöst.

Da in diesem zweiten Beispiel der vertikale Positionsverlauf des Greifers während der Erstarrung nicht zeitgesteuert, sondern spannungs- und/oder kraftgeregelt ist, wird der Aufbau von Spannungen und Zugkräften im Wesentlichen vermieden. Gegebenenfalls können Messwerte während des Erstarrungsvorgangs aufgezeichnet und zu Zwecken der Qualitätssicherung protokolliert werden. Ausserdem ist es möglich, aufgezeichnete Messwerte als Basis für eine Fuzzy-Logik zu verwenden. So ist es beispielsweise realisierbar, die spannungsfrei erreichte Endposition zu messen, den erreichten Ist-Positionswert mit dem Soll-Positionswert zu vergleichen, die Differenz zu berechnen und die Vor-Positionierung des nächsten Bauteils entsprechend zu korrigieren, so dass im jeweils nachfolgenden Befestigungsvorgang entsprechend verbesserte Positionsgenauigkeiten erzielt werden.

Nachfolgend werden die erfindungsgemässe Greifvorrichtung und zum Teil das erfindungsgemässe Verfahren anhand von unterschiedlichen schematischen und konkreten Ausführungsbeispielen in Form von Zeichnungen detailliert dargestellt. Im Einzelnen zeigen:
- Fig. 1: eine schematische Darstellung eines Greifers mit einem Kraftsensor;
- Fig. 2: eine schematische Darstellung eines Greifers mit einem Positionsdetektor; und
- Fig. 3: eine konkrete Ausführungsform des in Fig. 2 schematisch dargestellten Greifers.

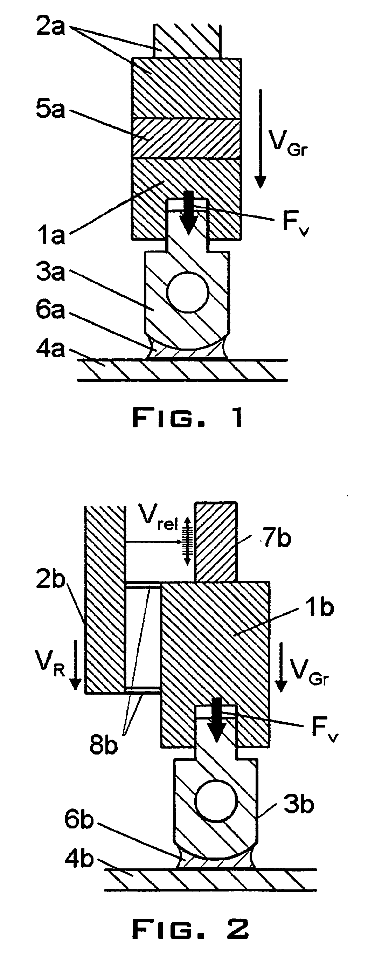

Fig. 1 zeigt schematisch einen Greifer 1a, der mit einer Roboterstation 2a verbunden ist, von welcher nur ein kleiner Ausschnitt in Form eines Armabschnitts dargestellt wird. Der Arm der Roboterstation 2a besitzt eine bestimmte Anzahl an Freiheitsgraden, ist jedoch zumindest in vertikaler Richtung V_{Gr} verstellbar. Der Greifer 1a hat beispielsweise den Aufbau eines aus dem Stand der Technik bekannten Greifers, bei dem die Greifkraft über einen Elektromagneten aufgebracht wird, und hält in Fig. 1 lösbar ein Mikro-Bauteil 3a mit einer sphärisch ausgebildeten Basis, die - im von Fig. 1 gezeigten Zustand - über erstarrendes Lötmaterial in Form einer Verbindungsnaht 6a mit einer Trägerplatte 4a in einer hochpräzise definierten Position verbunden ist. Da sich die Verbindungsnaht 6a in einem abkühlenden Zustand befindet, unterliegt sie einer Schrumpfung. Somit wird eine vertikale Zugkraft Fᵥ auf den im Wesentlichen nicht nachgiebigen Greifer 1a ausgeübt. Der Greifer 1a verfügt über einen vertikaler Kraftsensor 5a zum präzisen Messen dieser vertikalen Zugkraft F_{V} zwischen dem Greifer 1a und dem Arm der Roboterstation 2a vor, während und nach dem Erstarrungsvorgang des geschmolzenen, das Mikro-Bauteil 3a mit der Trägerplatte 4a verbindenden Lötmaterials in Form der Verbindungsnaht 6a. Der Kraftsensor 5a wird von einem bekannten Kraftsensor - beispielsweise einem Piezo-Sensor - gebildet. In Abhängigkeit von der gemessenen Zugkraft Fᵥ und gegebenenfalls der Zeit und/oder der Lötmaterialtemperatur wird der Greifer 1a von der Roboterstation in vertikaler Richtung V_{Gr} senkrecht zur Trägerplatte 4a verstellt, gegebenenfalls bis zu einer bestimmten vertikalen Soll-Position.

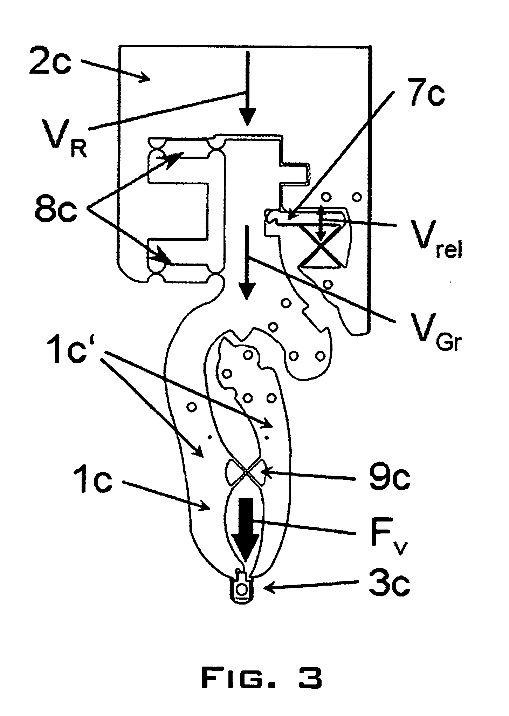

Fig. 2 zeigt einen Greifer 1b, der ein Mikro-Bauteil 3b mit einer ebenfalls sphärisch ausgebildeten Basis festhält, die - im von Fig. 2 gezeigten Zustand - über erstarrendes Lötmaterial in Form einer Verbindungsnaht 6b mit einer Trägerplatte 4b in einer hochpräzise definierten Position verbunden ist. Der Greifer 1b ist über Federn 8b an einer Robotermontagestation 2b angeordnet, von welcher lediglich ein zumindest in vertikaler Richtung V_{R} verstellbarere Armabschnitt dargestellt ist. Die Federn 8b ermöglichen eine geringfügige relative Verschiebbarkeit Vᵣₑₗ des Greifers 1b gegenüber dem Armabschnitt der Robotermontagestation 2b in vertikaler Richtung. Diese vertikale Verschieblichkeit Vᵣₑₗ ist über das Hooke'sche Gesetz abhängig von der vertikal an dem Greifer 1b angreifenden Kraft F_{V} und der Federkonstanten der Federn 8b. Zur Messung dieser vertikalen Verschiebung Vᵣₑₗ, aus der die vertikale Kraft F_{V} ableitbar ist, ist am Greifer 1b ein vertikaler Positionsdetektor 7b angebracht, der die relative vertikale Position Vᵣₑₗ des Greifers 1b gegenüber der Position V_{R} des Armabschnitts der Robotermontagestation 2b misst. Diese vertikale relative Verschiebbarkeit Vᵣₑₗ dient somit vor allem zu Zwecken der Kraftmessung mittels Wegmessung und ist so gering, dass die elastische Nachgiebigkeit des Greifers klein in Verhältnis zu der vertikalen Schrumpfung der Verbindungsnaht 6b bei den auftretenden Kräften ist. Die Kompensation von Spannungen durch Vermeidung einer zu hohen vertikalen Kraft F_{V} erfolgt durch Verstellen des Armes der Roboterstation 2b in vertikaler Richtung V_{R}. Durch das Abkühlen des Lötmaterials 6b schrumpft dieses und ruft somit die vertikale Kraft F_{V} auf dem Greifer in Richtung zur Trägerplatte 4b hervor. Das Mikro-Bauteil 3b wird samt dem Greifer 1b in Schrumpfungsrichtung, d.h. vertikal zur Trägerplatte 4b, zunächst geringfügig über die Federn 8b nachgezogen. Somit kommt es zu einer vertikalen relativen Positionsverschiebung Vᵣₑₗ des Greifers 1b gegenüber dem Arm der Roboterstation 2b. Diese vertikale relative Positionsverschiebung Vᵣₑₗ wird vom Positionsdetektor 7b erfasst, worauf ein Rückkopplungssignal an die Robotermontagestation 2b gesendet wird, um die vertikale Positionseinstellung V_{R} des Arm der Roboterstation 2b und die Position V_{Gr} des Greifers 1b derart vertikal nachzujustieren, so dass die durch die Schrumpfung verursachte vertikale relative Verschiebung Vᵣₑₗ des Greifers 1b gegenüber dem Arm der Robotermontagestation 2b wieder ausgeglichen wird und somit die vertikale Zugkraft F_{V} verringert wird. Die vertikale Position V_{Gr} des Greifers 1b lässt sich aus der Summe der vertikalen Position V_{R} des Armes der Roboterstation 2b und der vertikalen relativen Positionsverschiebung Vᵣₑₗ ableiten.

Fig. 3 zeigt eine konkrete Ausführungsform des in Fig. 2 schematisch dargestellten Greifers 1b. Der dargestellte Greifer 1c weist zwei Greiffinger 1c' auf, die durch ein Gelenk 9 miteinander verbunden sind, über das die mittels eines Elektromagneten eingeleitete Greifkraft umgelenkt wird. Die Greiffinger 1c' fassen im gezeigten Zustand ein Mikro-Bauteil 3c. Der Greifer 1c ist über Federn 8c mit einem zumindest vertikal um V_{R} verstellbaren Arm einer Roboterstation 2c verbunden. Der Greifer ist somit in vertikaler Richtung geringfügig um die vertikale relative Positionsverschiebung Vᵣₑₗ beweglich, die von einem Positionsdetektor 7c erfassbar ist. Aus der Federkonstanten der Federn 8c und der vertikalen relativen Positionsverschiebung Vᵣₑₗ ist eine Zugkraft Fᵥ, die das Mikro-Bauteil 3c auf den Greifer 1c ausübt, ableitbar.

## Patentansprüche

1. Verfahren zum Fixieren eines miniaturisierten - insbesondere mindestens ein optisches Element tragenden oder enthaltenden - Bauteils (3a, 3b, 3c) auf einer Trägerplatte (4a, 4b) durch eine Löt-, Schweiss- oder Klebeverbindung mit den Schritten:
• Fassen und Festhalten des Bauteils (3a, 3b, 3c) mit einem Greifer (1a, 1b 1c) einer Roboterstation (2a, 2b, 2c),
• Positionieren des Bauteils (3a, 3b, 3c) mit dem Greifer (1a, 1b, 1c) durch die Roboterstation (2a, 2b, 2c) über oder auf der Trägerplatte (4a, 4b) relativ zu äusseren Bezugspunkten,
• Herstellen einer Verbindung zwischen dem Bauteil (3a, 3b, 3c) und der Trägerplatte (4a, 4b) durch Löten, Schweissen oder Kleben, wobei
∘ eine bei dem Herstellen entstehende Verbindungsnaht (6a, 6b) zwischen dem Bauteil (3a, 3b, 3c) und der Trägerplatte (4a, 4b) unter Schrumpfung erstarrt und somit eine Zugkraft auf den Greifer (1a, 1b, 1c) in senkrechter Richtung zur Trägerplatte (4a, 4b) ausübt und
∘ der Greifer (1a, 1b, 1c) der Zugkraft durch eine Bewegung in senkrechter Richtung zur Trägerplatte (4a, 4b) nachgibt, und
• Lösen des Greifers (1a, 1b, 1c) vom Bauteil (3a, 3b, 3c), nachdem die Verbindungsnaht (6a, 6b) im Wesentlichen erstarrt ist,
**dadurch gekennzeichnet, dass**
im Schritt des Herstellens der Verbindung zwischen dem Bauteil (3a, 3b, 3c) und der Trägerplatte (4a, 4b) die Zugkraft durch eine gesteuerte oder geregelte, das Nachgeben bildende, aktive Bewegung des Greifers (1a, 1b, 1c) in Richtung zur Trägerplatte (4a, 4b) - zumindest teilweise - kompensiert wird.

2. Verfahren nach Anspruch 1, wobei das Kompensieren im Wesentlichen kontinuierlich, insbesondere während des gesamten Erstarrungsvorgangs der Verbindungsnaht (6a, 6b), erfolgt.

3. Verfahren nach einem der Ansprüche 1 bis 2, wobei
• die Zugkraft durch die gesteuerte oder geregelte aktive Bewegung des Greifers (1a, 1b, 1c) in Richtung zur Trägerplatte (4a, 4b) bis zur einer definierten vertikalen Soll-Position kompensiert wird und
• nach Erreichen der vertikalen Soll-Position die aktive Bewegung des Greifers (1a, 1b, 1c) angehalten oder reduziert wird.

4. Verfahren nach einem der Ansprüche 1 bis 3, wobei die Bewegung des Greifers (1a, 1b, 1c) gesteuert durch eine automatische Sequenz nach einem Algorithmus erfolgt, der auf den Materialeigenschaften der Verbindungsnaht (6a, 6b) basiert.

5. Verfahren nach Anspruch 4, wobei in einem Schritt vor dem Kompensieren der Zugkraft eine Umgebungstemperatur gemessen wird und der Algorithmus in Abhängigkeit von der gemessenen Umgebungstemperatur angepasst wird.

6. Verfahren nach einem der Ansprüche 1 bis 3, wobei die Bewegung des Greifers (1a, 1b, 1c) geregelt durch einen Regelkreis erfolgt.

7. Verfahren nach Anspruch 6, wobei
• die Führungsgrösse des Regelkreises direkt oder indirekt durch eine mechanische Soll-Spannung an der Verbindungsnaht (6a, 6b) gebildet wird,
• die Regelgrösse des Regelkreises direkt oder indirekt durch eine mechanische Ist-Spannung, die mit der Zugkraft verknüpft ist, an der Verbindungsnaht (6a, 6b) gebildet wird, und
• das Angleichen der Ist-Spannung an die Soll-Spannung durch die aktive Bewegung des Greifers (1a, 1b, 1c) in Richtung zur Trägerplatte (4a, 4b) erfolgt.

8. Verfahren nach Anspruch 7, wobei
• vor dem unter Schrumpfung erfolgenden Erstarren der Verbindungsnaht (6a, 6b) eine mechanische Spannung an der Verbindungsnaht direkt oder indirekt - insbesondere durch ein Ermitteln einer Ist-Zugkraft - ermittelt wird und
• die ermittelte Spannung die Soll-Spannung bildet.

9. Verfahren nach Anspruch 7 oder 8, wobei
• die Soll-Spannung durch eine vertikalen Soll-Zugkraft vorgegeben wird, und
• die Ist-Spannung durch eine gemessene vertikale Ist-Zugkraft gebildet wird.

10. Verfahren nach einem der Ansprüche 6 bis 9, wobei eine an den Greifer (1a, 1b, 1c) angreifende vertikale Ist-Zugkraft (F_{V}) ermittelt wird.

11. Verfahren nach Anspruch 10, wobei die vertikale Ist-Zugkraft (F_{V}) über einen Kraftsensor (5a) am Greifer (1a) ermittelt wird.

12. Verfahren nach Anspruch 10, wobei die vertikale Ist-Zugkraft (F_{V}) ermittelt wird, indem
• der Greifer (1b, 1c) relativ zur Roboterstation (2b, 2c) und senkrecht zur Trägerplatte (4b, 4c) elastisch beweglich ist und
• die relative vertikale Position (Vᵣₑₗ) des Greifers (1b, 1c) zur Roboterstation (2b, 2c) gemessen wird.

13. Verfahren nach Anspruch 12, wobei die relative vertikale Position (Vᵣₑₗ) des Greifers (1b, 1c) zur Roboterstation (2b, 2c) mittels eines Positionsdetektors (7b, 7c) gemessen wird.

14. Roboterstation (2a, 2b) mit einem Greifer (1a, 1b), der zum Fassen, Festhalten und Positionieren eines miniaturisierten Bauteils (3a, 3b, 3c) relativ zu äusseren Bezugspunkten über einer Trägerplatte (4a, 4b), die für ein Montageverfahren geeignet ist, bei dem das Bauteil (3a, 3b, 3c) auf der Trägerplatte (4a, 4b) durch Löten, Schweissen oder Kleben fixiert wird, wobei eine beim Löten, Schweissen oder Kleben entstehende Verbindungsnaht (6a) zwischen dem Bauteil (3a, 3b) und der Trägerplatte (4a, 4b) unter Schrumpfung erstarrt, ausgebildet ist, wobei dem Greifer (1a, 1b, 1c) ein Kraftsensor zur Messung einer auf den Greifer (1a, 1b, 1c) in senkrechter Richtung zur Trägerplatte (4a, 4b) angreifenden Kraft (F_{V}) zugeordnet ist
**dadurch gekennzeichnet, dass**
die Roboterstation derart ausgebildet ist, dass der Greifer (1a, 1b, 1c) von der Roboterstation in Abhängigkeit von der gemessenen Kraft (F_{V}) in der senkrechten Richtung während der Schrumpfung verstellt wird.

15. Roboterstation nach Anspruch 14,
**dadurch gekennzeichnet, dass**
• der Greifer (1b, 1c) relativ zur Roboterstation (2b, 2c) und senkrecht zur Trägerplatte (4b) elastisch beweglich ist und
• dem Greifer (1b, 1c) ein Positionsdetektor (7b, 7c) zur Messung der relativen vertikalen Position (Vᵣₑₗ) des Greifers (1b, 1c) zur Roboterstation (2b, 2c) derart zugeordnet ist, dass die angreifende Kraft (F_{V}) ableitbar ist.

16. Roboterstation nach Anspruch 15,
**dadurch gekennzeichnet, dass**
der Greifer (1b, 1c) zur Ermöglichung der elastischen Beweglichkeit über mindestens eine Feder (8b, 8c) mit der Roboterstation (2b, 2c) mittelbar oder unmittelbar verbunden ist.

17. Roboterstation nach einem der Ansprüche 14 bis 16,
**dadurch gekennzeichnet, dass**
ein Elektromagnet zum Fassen und Festhalten des miniaturisierten Bauteils (3a, 3b, 3c) dem Greifer (1a, 1b, 1c) zugeordnet ist.

18. System zum Fixieren eines miniaturisierten - insbesondere mindestens ein optisches Element tragenden oder enthaltenden - Bauteils (3a, 3b, 3c) auf einer Trägerplatte (4a, 4b) durch eine Löt-, Schweiss- oder Klebeverbindung, welches System
• die Roboterstation (2a, 2b, 2c) nach einem der Ansprüche 14 bis 17 mit dem Greifer, der in zumindest eine Richtung senkrecht zur Trägerplatte (4a, 4b) bewegbar und positionierbar ist,
• eine Einrichtung zur Herstellen der Verbindung zwischen dem Bauteil (3a, 3b, 3c) und der Trägerplatte (4a, 4b),
• wie beispielsweise eine Laserlöteinrichtung, und
• eine Steuerungs-Regelungs-Einheit zum Steuern und/oder Regeln zumindest
□ des Fassens und Festhalten des Bauteils (3a, 3b, 3c) mit dem Greifer (1a, 1b, 1c),
□ der Bewegung des Greifers (1a, 1b, 1c) mit der Roboterstation (2a, 2b, 2c) und
□ der Herstellung der Verbindung mit der Vorrichtung zur Herstellen der Verbindung,
aufweist.

## Claims

1. Method for fixing a miniaturised component (3a, 3b, 3c) - in particular carrying or containing at least one optical element - on a carrier plate (4a, 4b) by a solder, weld or adhesive joint, comprising the steps:
• gripping and holding the component (3a, 3b, 3c) with a gripper (1a, 1b, 1c) of a robot station (2a, 2b, 2c),
• positioning the component (3a, 3b, 3c) with the gripper (1a, 1b, 1c) by means of the robot station (2a, 2b, 2c) over or on a carrier plate (4a, 4b) relative to external reference points,
• producing a joint between the component (3a, 3b, 3c) and the carrier plate (4a, 4b) by soldering, welding or adhesive bonding,
o a joint seam (6a, 6b) which forms during production between the component (3a, 3b, 3c) and the carrier plate (4a, 4b) solidifying with shrinkage and thus exerting a tensile force on the gripper (1a, 1b, 1c) in the direction perpendicular to the carrier plate (4a, 4b) and
o the gripper (1a, 1b, 1c) yielding to the tensile force by a movement in the direction perpendicular to the carrier plate (4a, 4b), and
• releasing the gripper (1a, 1b, 1c) from the component (3a, 3b, 3c) after the joint seam (6a, 6b) has substantially solidified,
**characterized in that**,
in the step comprising the production of the joint between the component (3a, 3b, 3c) and the carrier plate (4a, 4b), the tensile force is - at least partly - compensated by a controlled or regulated, active movement of the gripper (1a, 1b, 1c), which generates the yield, in the direction towards the carrier plate (4a, 4b).

2. Method according to Claim 1, the compensation being effected substantially continuously, in particular during the entire solidification process of the joint seam (6a, 6b).

3. Method according to either of Claims 1 and 2,
• the tensile force being compensated by the controlled or regulated active movement of the gripper (1a, 1b, 1c) in the direction towards the carrier plate (4a, 4b) up to a defined vertical required position and
• the active movement of the gripper (1a, 1b, 1c) being stopped or reduced after reaching the vertical required position.

4. Method according to any of Claims 1 to 3, the movement of the gripper (1a, 1b, 1c) taking place with control by an automatic sequence according to an algorithm which is based on the material properties of the joint seam (6a, 6b).

5. Method according to Claim 4, an ambient temperature being measured and the algorithm being adapted as a function of the measured ambient temperature in a step prior to the compensation of the tensile force.

6. Method according to any of Claims 1 to 3, the movement of the gripper (1a, 1b, 1c) being effected with control by a control loop.

7. Method according to Claim 6,
• the command variable of the control loop being formed directly or indirectly by a required mechanical tension at the joint seam (6a, 6b),
• the controlled variable of the control loop being formed directly or indirectly by an actual mechanical tension, which is linked to the tensile force, at the joint seam (6a, 6b), and
• the matching of the actual tension to the required tension being effected by the active movement of the gripper (1a, 1b, 1c) in the direction towards the carrier plate (4a, 4b).

8. Method according to Claim 7,
• a mechanical tension at the joint seam being determined directly or indirectly - in particular by a determination of an actual tensile force - before the solidification of the joint seam (6a, 6b) which takes place with shrinkage and
• the tension determined forming the required tension.

9. Method according to Claim 7 or 8,
• the required tension being predetermined by a required vertical tensile force and
• the actual tension being formed by a measured actual vertical tensile force.

10. Method according to any of Claims 6 to 9, an actual vertical tensile force (Fᵥ) applied to the gripper (1a, 1b, 1c) being determined.

11. Method according to Claim 10, the actual vertical tensile force (Fᵥ) being determined by means of a force sensor (5a) on the gripper (1a).

12. Method according to Claim 10, the actual vertical tensile force (Fᵥ) being determined by a procedure in which
• the gripper (1b, 1c) is elastically moveable relative to the robot station (2b, 2c) and perpendicular to the carrier plate (4b, 4c) and
• the vertical position (Vᵣₑₗ) of the gripper (1b, 1c) relative to the robot station (2b, 2c) is measured.

13. Method according to Claim 12, the vertical position (Vᵣₑₗ) of the gripper (1b, 1c) relative to the robot station (2b, 2c) being measured by means of a position detector (7b, 7c).

14. Robot station (2a, 2b) comprising a gripper (1a, 1b) which is formed for gripping, holding and positioning a miniaturised component (3a, 3b, 3c) relative to external reference points over a carrier plate (4a, 4b) which is suitable for a mounting process, in which the component (3a, 3b, 3c) is fixed on the carrier plate (4a, 4b) by soldering, welding or adhesive bonding, a joint seam (6a), forming during the soldering, welding or adhesive bonding, between the component (3a, 3b) and the carrier plate (4a, 4b) solidifying with shrinkage, a force sensor for measuring a force (Fᵥ) applied to the gripper (1a, 1b, 1c) in the direction perpendicular to the carrier plate (4a, 4b) being coordinated with the gripper (1a, 1b, 1c), **characterized in that** the robot station is formed in such a way that the gripper (1a, 1b, 1c) is displaced by the robot station as a function of the measured force (Fᵥ) and the perpendicular direction during the shrinkage.

15. Robot station according to Claim 14, **characterized in that**
• the gripper (1b, 1c) is elastically moveable relative to the robot station (2b, 2c) and perpendicular to the carrier plate (4b) and
• a position detector (7b, 7c) for measuring the vertical position (Vᵣₑₗ) of the gripper (1b, 1c) relative to the robot station (2b, 2c) is coordinated with the gripper (1b, 1c) in such a way that the applied force (Fᵥ) can be derived.

16. Robot station according to Claim 15, **characterized in that** the gripper (1b, 1c) is connected indirectly or directly to the robot station (2b, 2c) via at least one spring (8b, 8c) for permitting the elastic mobility.

17. Robot station according to any of Claims 14 to 16, **characterized in that** an electromagnet for gripping and holding the miniaturised component (3a, 3b, 3c) is coordinated with the gripper (1a, 1b, 1c).

18. System for fixing a miniaturised component (3a, 3b, 3c) - in particular carrying or containing at least one optical element - on a carrier plate (4a, 4b) by a solder, weld or adhesive joint, which system comprises
• the robot station (2a, 2b, 2c) according to any Claims 14 to 17 comprising the gripper which is moveable and can be positioned in at least one direction perpendicular to the carrier plate (4a, 4b),
• a device for producing the joint between the component (3a, 3b, 3c) and the carrier plate (4a, 4b), such as, for example, a laser soldering device, and
• a control-regulation unit for controlling and/or regulating at least
o the gripping and holding of the component (3a, 3b, 3c) by the gripper (1a, 1b, 1c),
o the movement of the gripper (1a, 1b, 1c) by the robot station (2a, 2b, 2c) and
o the production of the joint by the apparatus for producing the joint.

## Revendications

1. Procédé pour fixer un composant (3, 3b, 3c) miniaturisé - composant portant ou contenant en particulier au moins un élément optique - sur une plaque de support (4a, 4b), par une liaison par brasage, soudage ou collage, présentant les étapes ci-après :
• saisie et fixation du composant (3a, 3b, 3c) avec un préhenseur (1a, 1b, 1c) d'une station de robot (2a, 2b, 2c),
• positionnement du composant (3a, 3b, 3c) avec le préhenseur (1a, 1b, 1c) par la station de robot (2a, 2b, 2c), au-dessus et à distance ou au-dessus et contre la plaque de support (4a, 4b), par rapport à des points de référence,
• fabrication d'un liaison entre le composant (3a, 3b, 3c) et la plaque de support (4a, 4b) par brasage, soudage ou collage, où
o un cordon de liaison (6a, 6b) produit lors de la fabrication, entre le composant (3a, 3b, 3c) et la plaque de support (4a, 4b, 4c), est solidifié avec rétraction et, ainsi, une force de traction est exercée sur le préhenseur (1a, 1b, 1c), en une direction perpendiculaire à la plaque de support (4a, b), et
o le préhenseur (1a, 1b, 1c) relâche la force de traction par un déplacement effectué dans une direction perpendiculaire à la plaque de support (4a, 4b), et
• détachement du préhenseur (1a, 1b, 1c) vis-à-vis du composant (3a, 3b, 3c), après que le cordon de liaison (6a, 6b) ait été pratiquement solidifié,
**caractérisé en ce que**,
à l'étape de fabrication de la liaison entre le composant (3a, 3b, 3c) et la plaque de support (4a, 4b), la force de traction est compensée - au moins partiellement - par un déplacement actif, commandé ou régulé, produisant le relâchement, du préhenseur (1a, 1b, 1c), dans la direction de la plaque de support (4a, 4b).

2. Procédé selon la revendication 1, la compensation s'effectuant de façon sensiblement continue, en particulier pendant l'ensemble du processus de solidification du cordon de liaison (6a, 6b).

3. Procédé selon l'une des revendications 1 à 2, où
• la force de traction est compensée par le déplacement actif, commandé ou régulé, du préhenseur (1a, 1b, 1c), dans la direction de la plaque de support (4a, 4b) jusqu'à une position de consigne verticale définie, et
• après atteinte de la position de consigne verticale, le déplacement actif du préhenseur (1a, 1b, 1c) est stoppé ou réduit.

4. Procédé selon l'une des revendications 1 à 3, le déplacement du préhenseur (1a, 1b, 1c) étant commandé par une séquence automatique, selon un algorithme basé sur les propriétés du matériau du cordon de liaison (6a, 6b).

5. Procédé selon la revendication 4, où, en une étape avant la compensation de la force de traction, une température ambiante est mesurée et l'algorithme est adapté en fonction de la température ambiante mesurée.

6. Procédé selon l'une des revendications 1 à 3, le déplacement du préhenseur (1a, 1b, 1c) étant régulé par un circuit de régulation.

7. Procédé selon la revendication 6, où
• la grandeur de guidage du circuit de régulation est formée, directement ou indirectement, par une contrainte de consigne mécanique, au cordon de liaison (6a, 6b),
• la grandeur de réglage du circuit de régulation est formée, directement ou indirectement, au cordon de liaison (6a, 6b), par une contrainte réelle mécanique, combinée à la force de traction, et
• l'adaptation de la contrainte réelle à la contrainte de consigne est effectuée par le déplacement actif du préhenseur (1a, 1b, 1c) dans la direction de la plaque de support (4a, 4b)

8. Procédé selon la revendication 7, où
• avant la solidification, s'effectuant avec retrait, du cordon de liaison (6a, 6b), une contrainte mécanique est déterminée, directement ou indirectement -, en particulier par une détermination d'une force de traction réelle -, et
• la contrainte déterminée forme la contrainte de consigne.

9. Procédé selon la revendication 7 ou 8, où
• la contrainte de consigne est prédéterminée par une force de traction de consigne verticale, et
• la contrainte réelle est formée par une force de traction réelle verticale mesurée.

10. Procédé selon l'une des revendications 6 à 9, une force de traction réelle (F_{V}) verticale, agissant sur le préhenseur (1a, 1b, 1c), étant déterminée.

11. Procédé selon la revendication 10, la force de traction réelle (FV) verticale étant déterminée par un capteur de force (5a) monté sur le préhenseur (1a, 1b, 1c).

12. Procédé selon la revendication 10, la force de traction réelle (FV) verticale étant déterminée en ce que :
• le préhenseur (1a, 1b, 1c) est mobile élastiquement par rapport à la station de robot (2b, 2c) et perpendiculairement par rapport à la plaque de support (4b, 4c), et
• la position verticale relative (Vᵣₑₗ) du préhenseur (1a, 1b, 1c) par rapport à la station de robot (2b, 2c) est mesurée.

13. Procédé selon la revendication 12, la position verticale relative (Vᵣₑₗ du préhenseur (1a, 1b, 1c) par rapport à la station de robot (2b, 2c) est mesurée au moyen d'un détecteur de position (7b, 7c).

14. Station de robot (2a, 2b) munie d'un préhenseur (1a, 1b, 1c), réalisé pour saisir, fixer et positionner un composant (3a, 3b,3c) miniaturisé, par rapport à des points de référence extérieurs, par l'intermédiaire d'une plaque support (4a, 4b) convenant pour un procédé de montage, dans lequel le composant (3a, 3b, 3c) est fixé sur la plaque de support (4a, 4b) par brasage, soudage ou collage, un cordon de liaison (6a), créé lors du brasage, soudage ou collage, entre le composant (3a, 3b) et la plaque de support (4a, 4b), se solidifiant avec retrait, au préhenseur (1a, 1b, 1c) étant associé un capteur de force, pour la mesure d'une force (F_{V}) agissant sur le préhenseur (1a, 1b, 1c), dans la direction perpendiculaire de la plaque support (4a, 4b),
**caractérisée en ce que**
la station de robot est réalisée de manière que le préhenseur (1a, 1b, 1c) soit réglé par la station de robot, dans la direction verticale, pendant le retrait, en fonction de la force (F_{V}) mesurée.

15. Station de robot selon la revendication 14, **caractérisée en ce que**
• le préhenseur (1a, 1b, 1c) est mobile élastiquement, par rapport à la station de robot (2b, 2c), et perpendiculairement, par rapport à la plaque de support (4ab), et
• un détecteur de position (7b, 7c) est associé au préhenseur (1b, 1c) pour la mesure de la position (Vᵣₑₗ) verticale relative du préhenseur (1b, 1c) par rapport à la station de base (2b, 2c), de manière que la force (F_{V}) agissant puisse être dérivée.

16. Station de robot selon la revendication 15,
**caractérisée en ce que**
le préhenseur (1b, 1c) est relié, indirectement ou directement, à la station de robot (2b, 2c) par l'intermédiaire d'un ressort (8b, 8c), pour permettre la mobilité élastique.

17. Station de robot selon l'une des revendications 14 à 16,
**caractérisée en ce qu'**un électroaimant est associé au préhenseur (1b, 1c), pour saisir et fixer le composant (3a, 3b, 3c) miniaturisé.

18. Système de fixation d'un composant (3a, 3b, 3c) miniaturisé - composant portant ou contenant en particulier au moins un élément optique - sur une plaque de support (4a, 4b) par une liaison brasée, soudée ou collée, le système présentant
• la station de robot (2a, 2b, 2c) selon l'une des revendications 14 à 17 avec le préhenseur, déplaçable et posit'ionnable en au moins une direction perpendiculairement par rapport à la plaque de support (4a, 4b),
• un dispositif pour fabriquer la liaison entre le composant (3a, 3b, 3c) et la plaque de support (4a, 4b) tel que, par exemple, un dispositif de brasage au laser, et
• une unité de régulation et de commande, pour commander/réguler au moins
o la saisie et la fixation du composant (3a, 3b, 3c) avec le préhenseur (1a, 1b, 1c),
o le déplacement du préhenseur (1a, 1b, 1c) avec la station de robot (2a, 2b, 2c), et
o la fabrication de la liaison au dispositif pour fabriquer la liaison.
